Europäisches Patentamt

European Patent Office

Office européen des brevets

(11) Publication number: **0 132 152**
**B1**

(12) **EUROPEAN PATENT SPECIFICATION**

(45) Date of publication of patent specification: **15.11.89**

(21) Application number: **84304876.0**

(22) Date of filing: **17.07.84**

(51) Int. Cl.⁴: **H 05 K 7/18,** H 05 K 7/20, H 05 K 5/00

(54) Modular computer system.

(30) Priority: **18.07.83 US 514675**

(43) Date of publication of application:
**23.01.85 Bulletin 85/04**

(45) Publication of the grant of the patent:
**15.11.89 Bulletin 89/46**

(84) Designated Contracting States:
**BE DE FR GB IT NL SE**

(56) References cited:
**EP-A-0 076 657**
**DE-A-3 041 546**
**DE-B-2 138 376**

(73) Proprietor: **DATA GENERAL CORPORATION**
**Route 9**
**Westboro Massachusetts 01581 (US)**

(72) Inventor: **Trombetta, Terry A.**
**1 Quial Roost Drive**
**Sterling Junction Massachusetts 01565 (US)**
Inventor: **Chin, Arthur W.**
**6 Fairlawn Street**
**North Grafton Massachusetts 01536 (US)**
Inventor: **Fortini, Edward C.**
**342 Peakham Road**
**Sudbury Massachusetts 01776 (US)**

(74) Representative: **Pears, David Ashley et al**
**REDDIE & GROSE 16 Theobalds Road**
**London WC1X 8PL (GB)**

Courier Press, Leamington Spa, England.

## Description

The present invention relates generally to a modular computer system of the kind set forth in the introductory part of claim 1.

In the past, the printed circuit boards and mechanical components implementing the various sub-systems of a computer system have usually been stacked vertically in a single cabinet type housing and secured in place with bolts or screws. The size and shape of the housing has been determined largely by the number, size and contents of the components of the sub-systems in the system at the time a system is purchased by a user. Very often, each sub-system includes its own power supply unit.

One of the problems with this arrangement is that the overall size of the cabinet and hence the space available inside the cabinet for mounting the elements of the sub-systems is fixed, leading to waste of space or inability to extend the system. Another problem is that because the components are stacked vertically, the cabinet is not particularly suited for mounting on a desk or table. The cabling used to interconnect the electrical elements is often very cumbersome and complicated, making installation and servicing rather difficult. Yet another problem is that any new boards that are added must be sized according to the dimensions of the cabinet.

A modular system which goes some way to meeting those problems and of the kind set forth in the introductory part of claim 1 is known from EP 0,076,657 (A2).

However the known system does not address the problem of providing cooling for all of the modules.

The present invention therefore provides a modular computer system as defined in claim 1 below.

The modules may be selectively combined, according to a user's requirements, into a computer unit that is a substantially rigid structure. The system does not require extensive cabling to connect the various units making up the system.

The system has a central cooling system and the module containing the power supply unit can power the entire system.

The computer system is suited for mounting on a desk or table. Each module can have substantially the same external configuration.

One computer system embodying the invention comprises three modules which are adapted to be positioned in a row in side-by-side relationship. Each module includes a rectangular box shaped chassis. One chassis contains a power supply unit, another chassis contains a central processing unit and the third chassis contains a data storage unit. Means are provided for use in interlocking adjacent chassis so as to provide a generally rigid structure and means are provided on the side walls of each chasssis for carrying the backplane signals from the unit in one chassis to the next.

The invention will be described in more detail, by way of example, with reference to the accompanying drawings, in which:

Fig 1 is a simplified perspective pictorial representation of an embodiment of a modular computer system constructed according to the present invention.

Fig 2 is a partially exploded view of the modular computer system of Fig 1, with one of the modules rotated slightly to show more clearly the mechanical coupling and locking arrangement and;

Fig 3 is a partially exploded and partially broken away view of the CPU module in the data processing system in Fig 1, with the CPU unit omitted.

The present invention is directed to a computer system which is made up of a plurality of modules which may be positioned in a row in side-by-side relationship, mechanicaly interlocked so as to form a generally rigid structure and electricaly interconnected so that electrical signals can be transmitted from one module to the next.

Each module includes a box shaped chassis containing a subsystem of a computer unit such as a power supply or a central processing unit. Each chassis is internally configured to accommodate the specific sub-system contained therein but is otherwise generaly similar to every other chassis. Each chassis contains a pair of electrical connectors, one on each side wall, so that it may be electrically connected to another chassis which may positioned adjacent thereto. Protrusions on one side wall of a chassis and holes on the other side wall enable adjacently positioned chassis to mate and slide bars insertable through the protrusions interlock adjacent chassis. A blower in one module generates a stresm of air which is used to cool all the modules.

The number and contents of the modules is dependent on the user's requirements.

One advantage of the invention is that the contents are flexible and can be easily changed by simply adding of removing modules or the contents within a module. Another advantage of the invention is that it does not require cabling for interconnecting sub-systems. Another advantage of the invention is that it lends itself to mounting on a desk or table top. Still another advantage of the invention is that a fully assembled system may be easily moved from one location to another.

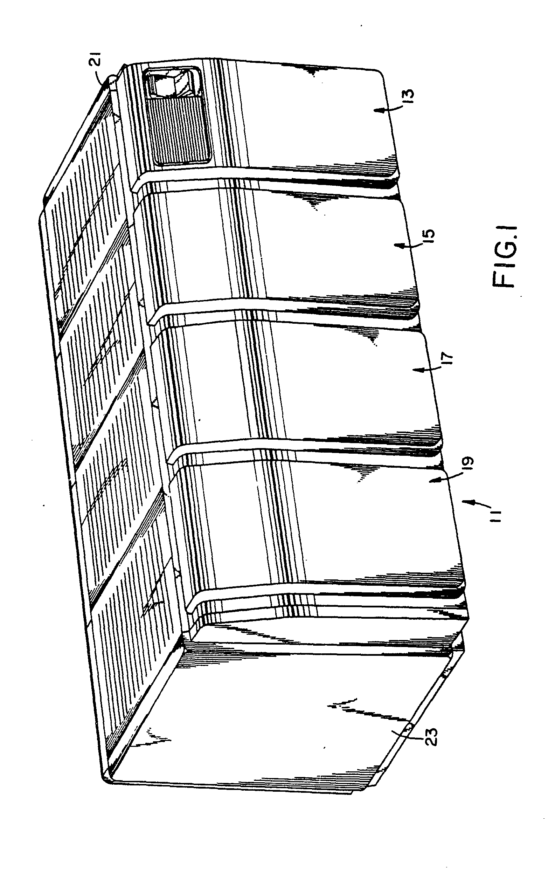

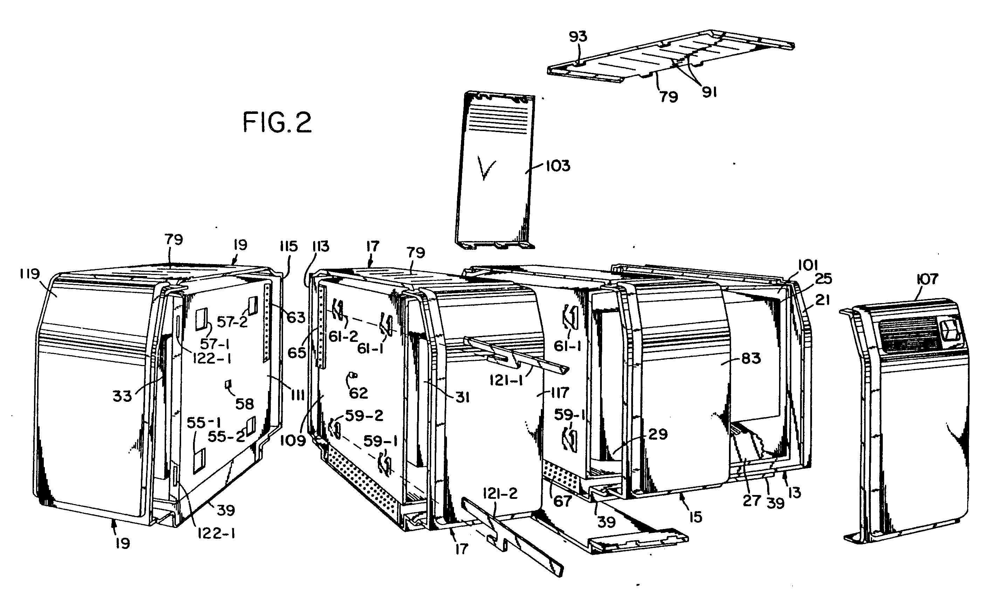

Referring now to the drawings, and first to Figs 1 and 2 there is illustrated an embodiment of a modular computer system constructed according to the teachings of the present invention and identified generally by reference numeral 11.

System 11 includes a first module 13 having a power supply unit, a second moudule 15 having a central processing unit, a third module 17 having a Winchester disk drive unit and a fourth module having 19 having a floppy disk drive unit.

It is to be understood that the number of modules shown is by way of example only. Theoretically, the minimum number of modules could be two, namely, a central processing unit module and a power supply unit module. However, in actuality, the minimum number of modules is preferably three, namely a power supply unit module, a central processing unit module and a data storage unit module. The maximum number of modules could be greater than four, the actual number and contents depending on the design characteristics of the units contained in the basic modules.

As can be seen, power unit module 13 is at the right end of the assembly, central processing unit module 15 is located next to the power unit module 13, Winchester unit module 17 is located next to the central processing unit module 15 and floppy disk module 19 is located next to Winchester unit module 17. Power unit module 13 is at the right end because it includes a blower which generates a stream of air that flows from right to left and the floppy disk module 19 is preferably located as far as possible from the blower so as not to be affected by the noise. Otherwise, the order in which the modules arranged is a matter of choice.

The modular assembly further includes a generally rectangular cover panel 21 at the right end and a generally rectangular cover panel 23 at the left hand. Panels 21 and 23 are plastic.

Each module includes electrical and/or mechanical components implementing the particular unit contained therein. Thus, module 13 includes a power supply 25 which provides operating power to each one of the other modules. In addition, module 13 also includes a blower 27 which generates a stream of cooling air which is used to cool all of the modules. Module 15 includes a central processing unit 29, module 17 includes a Winchester disk drive 31 and module 19 includes a floppy disk drive 33. For simplicity, the components implementing these units are shown simply as blocks, the particular details of each unit not being a part of the invention.

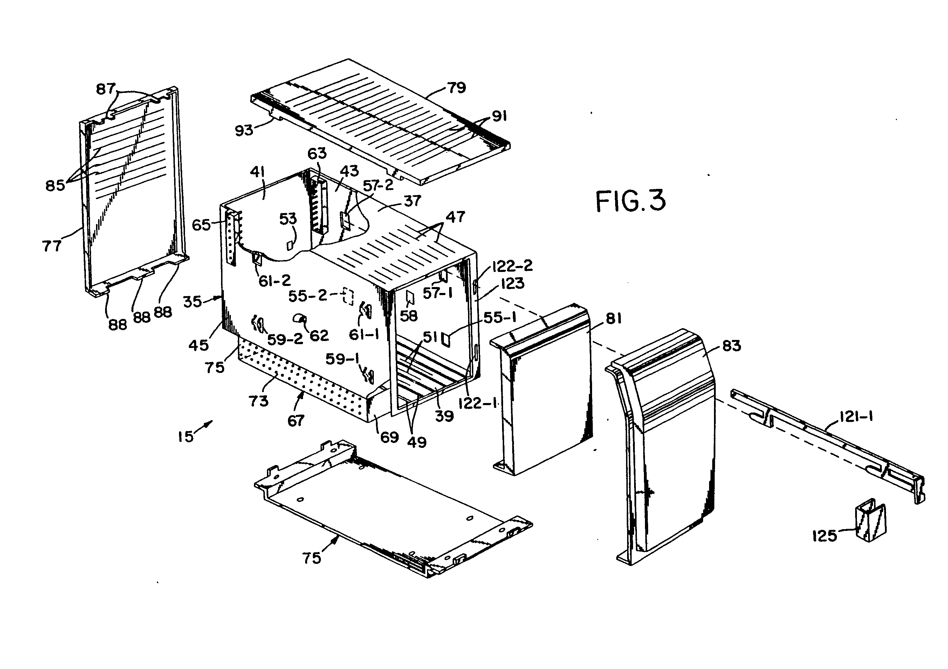

The details of construction of central processing unit module 15 are more clearly shown in Fig 3. For simplicity, the CPU 29 (block) is omitted.

As can be seen, module 15 includes a generally rectangular box shaped chassis 35 which is made of metal and which includes a rectangular back wall 41, a rectangular right side wall 43, a rectangular left side wall 45 and an open front. Chassis 35 may be 115 mm wide by 130 mm high by 305 mm deep. The walls 37, 39, 41 and 43 are fixedly secured to one another by any suitable means, such as welding. Top wall 37 includes a plurality of ventilation slots 47. Bottom wall 39 includes a plurality of internally formed grooves 49 for holding printed circuit boards (of CPU 29) and a plurality of ventilation slots 51. Back wall 41 contains a hole 53, for a switch (not shown) for CPU 29. A first pair of locking boles 55—1 and 55—2, a second pair of locking holes 47—1 and 57—2 and an aligning hole 58 are formed in right side walls 43. A first pair of locking protrusions 59—1 and 59—2, a second pair of locking protrusions 61—1 and 61—2 and an aligning protrusion 62 are formed in left side wall 45. A female connector 63 is fixedly mounted by a suitable means (not shown) in an opening on right side walls 43 near the back and a male connector 65 is fixedly mounted by a suitable means (not shown) in an opening on left side wall 45 near the back. Connector 63 is used to electrically connect module 15 to module 13 while connector 65 is used to electrically connect module 15 to module 17. Connectors 63 and 65 are each coupled to a printed circuit board (not shown) in CPU 29.

Locking holes 55 and 57 and locking protrusions 59 and 61 are used for interlocking chassis 35 to its adjacent chassis as will hereinafter be explained. Aligning hole 58 and aligning protrusion 62 are used for aligning chassis 35 with its adjacent chassis and the two connectors 63 and 65 are used for passing backplane signals from chassis 35 to the chassis adjacent thereto.

A baffle 67 which is made of metal or other suitable material, is mounted underneath chassis 35 and fixedly secured thereto by any suitable means such as screws, not shown. Baffle 67 which has the general configuration of a U-shaped bracket includes a front wall 69, a perforated side wall 71, a back wall 75, an open bottom and an open top. The perforations on side wall 71 enable a portion of a stream of air impinging thereon to pass through (as will hereinafter be explained).

A rectangular channel shaped base plate 75 which is made of metal is fixedly attached to the chassis 35 underneath baffle 67 by screws (not shown). Besides serving as a support for chassis 35, base plate 75 functions as a plenum or air duct, as will be hereinafter explained.

Module 15 further includes a back cover panel 77, a top cover panel 79, a shield plate 81 and a front cover panel 83.

Back cover 77 is made of plastic, includes a plurality of ventilation slots 85 and is provided with a set of tabs 87 and 88 so that it may be snap locked onto base plate 75 and top cover panel 79. Top cover panel 79 is made of plastic, includes a plurality of ventilation slots 91 and is provided with a set of tabs 93 on each side edge so that it may be snap locked onto chassis 35. Shield plate 81 is made of metal and is snap locked onto chassis 35. Front cover 83 is made of plastic and is snap locked onto top cover 43 and base plate 75. Shield plate 81 serves as an electrical shield.

Module 13 includes a chassis 101, a base plate 39, a baffle 67 and a set of covers 103, 91 and 107. Chassis 101 differs from chassis 35 only in its internal configuration (to accommodate the different components contained therein). Covers 103 and 107 differ from covers 77 and 83 with respect to their access slots (if any). Modules 17 and 19 each include a chassis, 109 and 111, respectively, a base plate 39, a baffle 67 and a set of back covers 113, and 115 respectively, a top cover 91 and a set of front covers 117 and 119 respectively. Modules 113, 17 and 19 may also include a shield plate 81, if needed. Chassis 109 and 111 differ from chassis 37 only in their internal configuration. Back covers 113 and 115 and front covers 117 and 119 differ from covers 41 and 47 only with respect to their access slots (if any).

When the modules are positioned side by side, the male protrusions 59 and 61 in the left side wall of one chassis extend through the slots 55 and 57 in right side wall of the left adjacent chassis and the aligning tab 62 on the left side wall of one chassis extends through aligning hole 58 in the right side wall of the left adjacent chassis. Adjacent chassis are locking together by a pair of slide bars 121—1 and 121—2 which extend through slots 122—1 and 122—2 formed in a flange 123 on each left side wall and through each pair of protrusions. Slide bars 121 are maintained in place by retaining clips 125 which clip over the slide bars onto flange 123.

In the operation of system 11, the modules are cooled by a flow of air generated by blower which is directed through the duct in each module and which exits through the ventilation slots formed in the chassis and covers. The perforated wall 73 in the baffle underneath each chassis directs a part of the stream cooling air up into the chassis and allows some of the air to pass through to the next module.

## Claims

1. A modular computer system comprising a plurality of modules (13, 15, 17, 19) each including a box shaped chassis, positioned side-by-side in a row, each module housing a unit of the computer system and having male and female electrical connectors (65 and 63) on its two sides respectively for electrically connecting adjacent modules, and means (55, 57, 59, 61, 121) for mechanically interlocking adjacent modules, characterized in that a first module (13) houses a power supply unit, a second module (15) houses a central processing unit, and a further module (17 or 19) houses a data storage unit, in that each chassis (35) includes a bottom wall (39), a top wall (37), a back wall (41), first and second side walls (43, 45) and an open front, and a base plate (75) mounted underneath the chassis (35) to form an air duct, further characterized in that the module (13) at one end of the row includes a blower (27) for blowing a stream of cooling air through the air duct extending beneath all modules and each module having a perforated baffle (67) in its air duct for directing some cooling air up into the chassis (35) of the module and allowing some cooling air to pass on to the next module.

2. A modular computer system according to claim 1, characterized in that the blower (27) is in the module (13) housing the power supply unit.

3. A modular computer system according to claim 1 or 2, characterized in that the means for mechanically interlocking adjacent modules comprise a plurality of locking holes (55, 57) in the first side wall (43) in each chassis, a plurality of locking protrusions (59, 61) on the second side wall (45) which extend through the locking holes in an adjacent chassis, and a removable slide bar (121) which is not connected to either chassis but is adapted to be inserted through the protrusions (59, 61).

## Patentansprüche

1. Modulares Computer-System mit einer Mehrzahl von Modulen (13, 15, 17, 19), die jeweils ein kastenförmiges Chassis enthalten, in einer Reihe nebeneinander angeordnet sind, eine Einheit des Computer-Systems aufnehmen und an beiden Seiten elektrische Steck- und Hülsenverbinder (65 und 63) zur elektrischen Verbindung benachbarter Module aufweisen, und mit Mitteln (55, 57, 59, 61, 121) zur mechanischen Verriegelung benachbarter Module, dadurch gekennzeichnet, daß ein erstes Modul (13) ein Netzgerät, ein zweiter Modul (15) eine Zentraleinheit und ein weiterer Modul (17 oder 19) eine Datenspeichereinheit aufnimmt, daß jedes Chassis (35) einen Boden (39), eine Deckwand (37), eine Rückwand (41), eine erste und eine zweite Seitenwand (43, 45), eine offene Vorderseite und eine unterhalb des Chassis (35) montierte Grundplatte (75) zur Bildung eines Luftkanals aufweist, und daß der Modul (13) am einen Ende der Reihe ein Gebläse (27) zum Durchblasen eines Kühlluftstroms durch den unterhalb aller Module erstreckten Luftkanal enthält, wobei jeder Modul in seinem Luftkanal eine perforierte Prallplatte (67) zur Umlenkung eines Teils der Kühlluft nach oben in das Chassis (35) des Moduls und zum Passierenlassen des anderen Teils der Kühlluft zum nächster Modul aufweist.

2. Modulares Computer-System nach Anspruch 1, dadurch gekennzeichnet, daß das Gebläse (27) in dem das Netzgerät aufnehmenden Modul (13) angeordnet ist.

3. Modulares Computer-System nach Anspruch 1 oder 2, dadurch gekennzeichnet, daß die Mittel zur mechanischen Verriegelung benachbarter Module eine Vielzahl von Verriegelungslöchern (55, 57) in der ersten Seitenwand (43) jedes Chassis, eine Vielzahl von die Verriegelungslöcher des benachbarten Chassis durchragenden Verriegelungsvorsprüngen (59, 61) in der, zweiten Seitenwand (45) und eine entfernbare, mit keinem Chassis verbundene, aber zum Durchschieben durch die Vorsprünge (59, 61) geeignete Gleitschiene (121) enthält.

## Revendications

1. Système modulaire d'ordinateur comportant une pluralité de modules (13, 15, 17, 19), dont chacun comprend un châssis en forme de boîte, placés côte-à-côte en une rangée, chaque module abritant une unité du système d'ordinateur et possédant des connecteurs électriques mâle et femelle (65 et 63) situés respectivement sur ses deux côtés et destinés à connecter électriquement des modules adjacents, et des moyens (55, 57, 59, 61, 121) de solidariser d'une manière mécanique des modules adjacents, caractérisé en ce qu'un premier module (13) abrite une unité d'alimentation énergétique, un second module (15) abrite une unité centrale de traitement, et un autre module (17 ou 19) abrite une unité de stockage de données, en ce que chaque châssis (35) comprend une paroi inférieure (39), une paroi supérieure (37), une paroi arrière (41), une première et une seconde parois latérales (43, 45) et une zone avant ouverte, ainsi qu'une plaque de base (75) montée au-dessous du châssis (35) de façon à constituer une conduite d'air, caractérisé de plus en ce que le module (13) situé à une extrémité de la rangée comprend une machine soufflante (27) destinée à souffler un courant d'air de refroidissement à travers la conduite d'air qui s'étend au-dessous de tous les modules, chaque module possédant un écran perforé (67) situé dans sa conduite d'air et destiné à diriger une certaine quantité d'air de refroidissement vers le haut jusque dans le châssis (35) de ce module et à permettre à une certaine quantité d'air de refroidissement de continuer de passer vers le module suivant.

2. Système modulaire d'ordinateur conforme à la revendication 1, caractérisé en ce que la machine soufflante (27) est située dans le module (13) abritant l'unité d'alimentation énergétique.

3. Système modulaire d'ordinateur conforme à la revendication 1 ou à la revendication 2, caractérisé en ce que les moyens de solidariser d'une manière mécanique des modules adjacents comportent une pluralité de trous de verrouilage (55, 57) ménagés dans la première paroi latérale (43) de chaque châssis, une pluralité de protubérances de verrouilage (59, 61) situées sur la seconde paroi latérale (45) et s'étendant à travers les trous de verrouillage ménagés sur un châssis adjacent, et un barreau coulissant (121) amovible qui n'est relié à aucun châssis mais qui est approprié pour être inséré à travers les protubérances (59, 61).

FIG.1

FIG.2

FIG.3